# EUROPEAN PATENT APPLICATION

(11) **EP 4 668 326 A1**
(43) Date of publication of application: **24.12.2025**
(21) Application number: 24182924.1
(22) Date of filing: 18.06.2024
(51) Int. Cl.: H01L 23/15, H01L 23/48, H01L 23/498, H01L 23/64

(54) **A LEADLESS PACKAGE COMPRISING A FIRST AND A SECOND SEMICONDUCTOR DIE, WHEREIN A GALVANIC ISOLATION IS PROVIDED BETWEEN THOSE SEMICONDUCTOR DIES, AS WELL AS A CORRESPONDING METHOD**

(71) Applicant: Nexperia B.V., 6534 AB Nijmegen (NL)
(72) Inventor: Gajanana, Deepak, Nijmegen (NL); Lam, Kan Wae, 6534 AB Nijmegen (NL); Flauta, Randolph Estal, Hong Kong (HK); Man, Chun Nga, Hong Kong (HK)
(74) Representative: Pjanovic, Ilija

(57) **Abstract**

A leadless package, comprising: a glass substrate; first and second electrically conductive interconnect route layers provided on a top side of said glass substrate, wherein the first and second electrically conductive interconnect route layers are isolated from each other; first and second electrically conductive top plates provided on said top side of said glass substrate; a first semiconductor die having at least two terminals, wherein a first of said two terminals is connected to the first electrically conductive interconnect route layer and a second of said at least two terminals is connected to said first electrically conductive top plate; a second semiconductor die having at least two terminals, wherein a first of said two terminals is connected to the second electrically conductive interconnect route layer and a second of said at least two terminals is connected to said second electrically conductive top plate; a first via through said glass substrate for enabling an electrical connection from a bottom side of said glass substrate to said first electrically conductive plate; a second via through said glass substrate for enabling an electrical connection from said bottom side of said glass substrate to said second electrically conductive plate; an inductive plate provided in or at said top side of said glass substrate, wherein said inductive plate is oriented such that an inductive coupling is provided between: said first electrically conductive plate and said inductive plate, and said second electrically conductive plate and said inductive plate.

## Description

### Technical field

The present disclosure generally relates to the field of leadless packaging and, more specifically, to leadless packages that comprise at least two galvanic isolated semiconductor dies.

### Background

Isolation plays an important role in ensuring seamless operations between semiconductor circuits operating at different voltage levels, allowing data exchange while preventing undesired current flow. Traditional methods have relied on a spectrum of components such as optocouplers, capacitors, transformers, or magnetic coils to achieve this isolation. However, these methods have inherent limitations, including bulkiness, limited bandwidth, and susceptibility to environmental factors like temperature and electromagnetic interference, EMI.

An alternative approach involves integrating isolators directly within semiconductor components. This method utilizes the inherent properties of the semiconductor materials, utilizing the metal inductance and insulating layers to fashion a inductance-based insulator. By doing so, the need for bulky external components is circumvented, leading to more compact designs and potentially enhanced performance.

Despite the advantages of integrated isolators, challenges persist. One significant limitation arises from the constraints on insulation distance within the semiconductor device itself. This limitation stems from the reliance on metal layers within the semiconductor's structure to create the necessary insulation barriers. As a result, the distance through insulation is inherently limited, posing risks of electrostatic discharge, ESD, and compromising the overall insulation performance.

Moreover, the pursuit of leadless packaging configurations introduces additional complexities. Leadless packages, while offering potential benefits such as reduced footprint and improved thermal management, present unique engineering challenges. One such challenge is the need for a split in the lead frame to accommodate the configuration, which can complicate manufacturing processes and introduce reliability risks. Additionally, the exposed pad characteristic of leadless packages necessitates specialized coatings to protect against environmental factors and ensure long-term reliability.

Furthermore, considerations of creepage and clearance become of importance in leadless package designs. Creepage refers to the distance that a surface-contaminating substance, such as dust or moisture, can travel along the surface of an insulating material. Clearance, on the other hand, denotes the shortest distance between two conductive parts or between a conductive part and the grounded surface. In leadless packages, where space is at a premium, maintaining adequate creepage and clearance distances becomes a critical design consideration to prevent electrical breakdown and ensure safety and reliability.

In view of these challenges, there is a growing demand for innovative solutions that address the limitations of conventional isolation techniques and overcome the hurdles associated with leadless package designs.

### Summary

It would be advantageous to achieve a leadless package that overcomes the difficulties as addressed above. It would further be advantageous to achieve a corresponding method of manufacturing such a leadless package.

In a first aspect of the present disclosure, there is provided a leadless package, comprising a glass substrate; first and second electrically conductive interconnect route layers provided on a top side of said glass substrate, wherein the first and second electrically conductive interconnect route layers are isolated from each other; first and second electrically conductive top plates provided on said top side of said glass substrate; a first semiconductor die having at least two terminals, wherein a first of said two terminals is connected to the first electrically conductive interconnect route layer and a second of said at least two terminals is connected to said first electrically conductive top plate; a second semiconductor die having at least two terminals, wherein a first of said two terminals is connected to the second electrically conductive interconnect route layer and a second of said at least two terminals is connected to said second electrically conductive top plate; a first via through said glass substrate for enabling an electrical connection from a bottom side of said glass substrate to said first electrically conductive plate; a second via through said glass substrate for enabling an electrical connection from said bottom side of said glass substrate to said second electrically conductive plate; an inductive plate provided in or at said top side of said glass substrate, wherein said inductive plate is oriented such that an inductive coupling is provided between: said first electrically conductive plate and said inductive plate, and said second electrically conductive plate and said inductive plate.

When glass is utilized as a substrate material, it offers several advantages. Firstly, glass, being an insulating material, effectively isolates the internal components of the semiconductor device from the external environment. This isolation is further enhanced when combined with electromagnetic compatibility, EMC, measures, which shield the device from external electromagnetic interference.

Another benefit of using glass as a substrate is that it eliminates the need for additional coatings to protect the device from environmental factors. In traditional packages, an exposed pad is often present, requiring specialized coatings to safeguard against moisture, dust, and other contaminants. However, in configurations utilizing a glass substrate, this exposed pad is no longer necessary.

The glass substrate itself provides inherent protection, acting as a barrier between the sensitive internal components of the device and the external surroundings.

The glass substrate may also provide structural strength, for example during molding of the semiconductor dies.

By leveraging glass as a substrate material and, possibly, integrating EMC measures, semiconductor devices can achieve robust isolation from the outside world without relying on additional coatings or exposed pads. This not only simplifies the manufacturing process but also enhances the reliability and longevity of the device, making it well-suited for a variety of applications in demanding environments.

The inventors have found that it may be beneficial to create a galvanic isolation between the first and second semiconductor dies. This is accomplished using the bottom electrically conductive plate provided in or at said bottom side of said glass substrate. In such a way, there is an inductive coupling between the first electrically conductive top plate and the bottom plate. There is also an inductive coupling between the second electrically conductive top plate and the bottom plate.

In other words, the connection between the two semiconductor dies may be viewed as two in series connected inductors. This enables galvanic isolation between the semiconductor dies and, at the same time, enable data to be exchanged between the semiconductor dies.

The galvanic connection includes the inductive coupling between the bottom plate and the first semiconductor die, more specifically to the first electrically conductive top plate and includes the inductive coupling between the bottom plate and the second semiconductor die, more specifically the second electrically conductive top plate.

It may be noted that the creation of the inductive coupling between the semiconductor dies does not require metal leads extending from the semiconductor dies. The electrically conductive top plates may be implemented as metal pads to which the corresponding semiconductor dies are directly mounted, for example using a technique as a surface mount technology.

The present disclosure is not limited to a specific example of a semiconductor die. The semiconductor die could, for example, be related to Integrated Circuits, which are chips that contain various electronic components such as transistors, resistors, capacitors, inductors, and diodes integrated onto a single semiconductor substrate.

Other examples include microprocessors and microcontrollers. These are specialized ICs designed to perform processing tasks in digital electronic devices. They contain a central processing unit, CPU, memory, and input/output peripherals on a single chip.

Even further examples include Power Devices. Semiconductor dies designed for power applications, such as power MOSFET, i.e. Metal-Oxide-Semiconductor Field-Effect Transistors, insulated-gate bipolar transistors, IGBTs, and diodes.

The present disclosure is directed to a leadless package. A leadless package, in the context of semiconductor dies, refers to a type of packaging used to encapsulate and protect the semiconductor chip without traditional metal leads extending from the package.

In the present scenario, at least two semiconductor dies are provided in the leadless package. Each semiconductor die is mounted on the glass substrate of the package substrate. The glass substrate contain multiple electrically conductive top plates for each die, facilitating electrical inductive connections between the semiconductor dies. The inductive coupling is obtained by utilizing a bottom plate.

In a further example, said inductive plate is electrically floating.

In a further example, said glass substrate is a monolithic glass substrate.

A monolithic glass substrate refers to a single piece of glass that serves as the foundation or base for the semiconductor dies. A monolithic glass substrate is used to provide a stable and reliable base for mounting and integrating the semiconductor dies.

These substrates may be made from high-purity glass materials, such as borosilicate or quartz, which offer improved thermal and mechanical properties, as well as compatibility with various fabrication processes. Monolithic glass substrates can be customized with precise dimensions, surface finishes, and features to accommodate specific device requirements.

In a further example, any of said terminals of said first and second semiconductor die are connected to said corresponding first or second electrically conductive interconnect route layers or said first or second electrically conductive top plates using an adhesive.

Electrically conductive adhesives may be materials formulated to provide both mechanical bonding and electrical conductivity when used to join two surfaces together. These adhesives may typically contain conductive particles, such as silver or nickel, dispersed within a polymer matrix.

When applying an electrically conductive adhesive between a semiconductor die and an electrically conductive plate, the adhesive forms a bond between the surfaces while also creating an electrical pathway. This enables the transfer of electrical signals or power between the corresponding semiconductor die and the electrically conductive plate. The adhesive may thus serve as both a bonding agent and a conductive medium, allowing for a reliable and electrically efficient connection.

In a further example, any of said terminals of said first and second semiconductor die are connected to said corresponding first or second electrically conductive interconnect route layers or said first or second electrically conductive top plates using solder material.

Soldering involves melting a solder material, typically an alloy containing tin and lead, or lead-free alternatives, and using it to create a metallurgical bond between the semiconductor die and the electrically conductive plate.

In a further example, the leadless package further comprises a mold surrounding said first and second semiconductor die.

The mold, also referred to as an encapsulant or encapsulation material, may serve different functions in semiconductor packaging. One of the purposes of the mold is to protect the semiconductor die from external environmental factors such as moisture, dust, mechanical damage, and chemical exposure. By encapsulating the die in a protective material, its longevity and reliability can be improved. The mold material may also aid to electrically isolate the semiconductor die from its surroundings, preventing unintended electrical contact or interference with other components or conductive elements. Further, the encapsulant may provide mechanical support to the semiconductor die, helping to absorb mechanical stresses and shocks encountered during handling, assembly, and operation.

In a further example, a distance between said bottom electrically conductive plate and any of said first and second electrically conductive top plates is preferably upto 40% of the height of the package and can be varied depending on the isolation rating requirements. This allows for a range of dimensions of the components of the package (such as the height/thickness of the glass substrate, the height/thickness of the mold compound, the height/thickness of the semiconductor die(s), etc) which can be adjusted but does not reduce performance of the package.

The advantage hereof is that a inductive coupling between the semiconductor dies can be warranted.

In yet another example, a shape of said bottom electrically conductive plate is any of rectangular, square, ellipse, circle, irregular polygons.

In a further example, the first and second semiconductor dies are mounted to said substrate using a flip-chip process.

The flip-chip technology is a method, wherein the semiconductor die is electrically connected to the glass substrate by flipping the die upside down and attaching it directly to the glass substrate using conductive means, typically made of solder or conductive adhesives.

In the context of creating a leadless package, the flip-chip process allows for direct electrical connections between the semiconductor die and the plates present on the glass substrate without the need for traditional wire bonding or lead frames.

In a second aspect of the present disclosure, there is provided a method of manufacturing a in accordance with any of the previous claims, wherein said method comprises the steps of:
- providing said glass substrate;
- providing said first and second via through said glass structure;
- depositing said first and second electrically conductive interconnect route layers on said top side of said glass substrate and depositing said first and second electrically conductive top plates on said top side of said glass substrate;
- mounting said first and second semiconductor dies on said substrate, and
- depositing a inductive plate on top of the on the glass substrate between said first and second semiconductor dies.

It is noted that the advantages as explained with respect to the first aspect of the present disclosure, being the leadless package, are also applicable to the second aspect of the present disclosure, being the method of manufacturing a leadless package.

In an example hereof, the glass substrate is a monolithic glass substrate.

In another example, the step of mounting said first and second semiconductor die comprises: mounting any of said terminals of said first and second semiconductor die to said corresponding first or second electrically conductive interconnect route layers or said first or second electrically conductive top plates using an adhesive.

In a further example, the step of mounting said first and second semiconductor die comprises: mounting any of said terminals of said first and second semiconductor die to said corresponding first or second electrically conductive interconnect route layers or said first or second electrically conductive top plates using solder material.

In an example, the method further comprises the step of: providing molding to said first and second semiconductor dies such that said leadless package further comprises a mold surrounding said first and second semiconductor die.

In another example, a distance between said inductive plate and any of said first and second electrically conductive top plates is in the order of least Sum for a requirement of 4kVrms (it is assumed that the dielectric strength of glass is around 500Vrms/um).

In an example, the step of mounting said first and second semiconductor dies on said substrate uses a flip-chip process

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the figures

Figs. 1a and 1b shows an example of a leadless package in accordance with the present disclosure;
Figs. 2a-2d disclose formation of vias, routing interconnects and inductive contacts in accordance with the present disclosure;
Figs. 3a-3d disclose a semiconductor leadless package assembly in accordance with the present disclosure.
Fig. 4 illustrates the shapes of the inductors in the plate in accordance with the present disclosure.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

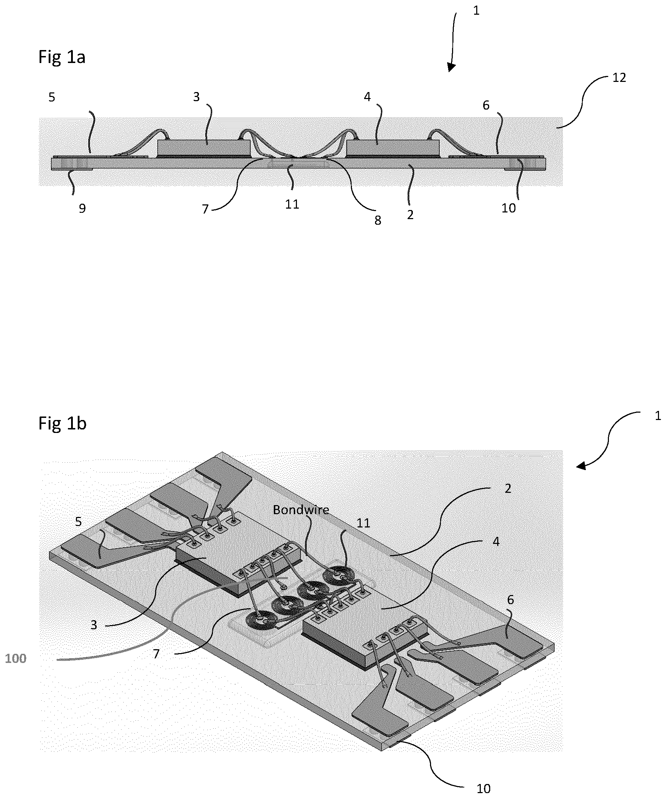

Figs. 1a and 1b show an example of a leadless package 1 in accordance with the present disclosure.

A leadless package refers to a type of packaging for semiconductor dies, or integrated circuits that lacks traditional lead wires extending from the semiconductor dies. Instead of having protruding leads, a leadless package typically has metal pads or terminals on its surface for electrical connections.

Leadless packages offer advantages such as smaller size, higher density, and better thermal performance compared to traditional leaded packages.

The leadless package comprises a glass substrate 2. The leadless package incorporates a glass substrate, providing a durable and thermally stable foundation for the semiconductor dies 3, 4.

Further, first and second electrically conductive interconnect route layers 5, 6 are provided on a top side of said glass substrate 2, wherein the first and second electrically conductive interconnect route layers 5, 6 are isolated from each other. This aspect involves the inclusion of distinct electrically conductive interconnect route layers on the top side of the glass substrate, ensuring separate pathways for electrical connections to the respective semiconductor dies without interference.

Next, first and second electrically conductive top plates 7, 8 are provided on said top side of said glass substrate. The leadless package features electrically conductive top plates positioned on the top side of the glass substrate, facilitate electrical connections within the package and, more specifically, to the respective semiconductor dies.

A first semiconductor die 3 is provided having at least two terminals, wherein a first of said two terminals is connected to the first electrically conductive interconnect route layer and a second of said at least two terminals is connected to said first electrically conductive top plate: This component encompasses the presence of a semiconductor die with multiple terminals, establishing connections between specific terminals and designated electrically conductive layers or plates within the package.

A second semiconductor die 4 is provided having at least two terminals, wherein a first of said two terminals is connected to the second electrically conductive interconnect route layer and a second of said at least two terminals is connected to said second electrically conductive top plate.

Similarly to the first semiconductor die, this aspect involves another semiconductor die with multiple terminals, with connections established between its terminals and specific electrically conductive layers or plates within the package.

Figs. 1a and 1b illustrate an embodiment according to an aspect of the present invention where the terminals of both the first and second semiconductor dies are positioned on one side (surface) of said semiconductor dies, namely the side facing away from the glass substrate 2 in the leadless package 1. This allows the opposite side of the semiconductor die to be attached to the glass substrate 2. This means that bond wires, or other connections means are necessary in order to connect both electrically conductive interconnect route layers 5, 6 (or metal interconnects for short) and the electrically conductive top plates 7, 8. This has the effect of optimizing the space within the package. However, the semiconductor dies may have terminals on other sides (or surfaces) of said semiconductor dies which can also be connected to the electrically conductive interconnect route layers 5, 6 and/or the electrically conductive top plates 7, 8 through other means, such as bond wires, solder balls, or other adhesive means. Such configurations may lead to more effective space usage within the package. In accordance to another embodiment of the present invention the conductive plates 7, 8 may be on the semiconductor surface facing the glass substrate, and thus could be positioned on top of the electrically conductive interconnect router layers 5, 6. Such a connection can made using solder balls and other adhesive methods.

A first via 9 is provided through said glass substrate for enabling an electrical connection from a bottom side of said glass substrate to said first electrically conductive plate. This aspect refers to a via passing through the glass substrate, facilitating an electrical connection from the bottom side of the substrate to the first electrically conductive top plate.

A second via 10 is provided through said glass substrate for enabling an electrical connection from said bottom side of said glass substrate to said second electrically conductive plate. Similar to the first via, this feature entails a via through the glass substrate, enabling an electrical connection from the bottom side of the substrate to the second electrically conductive top plate.

A bottom electrically inductive plate 11, also knows as a transformer plate, is provided in or at said bottom side of said glass substrate 2, wherein said bottom electrically inductive plate 11 is oriented such that an inductive coupling is provided between the bottom plate and the first and, respectively, second electrically conductive top plates.

The inclusion of the bottom electrically conductive plate thus allows for a inductive coupling between the semiconductor dies. Preferably, the bottom electrically conductive plate is electrically floating.

When connecting the inductive plate 11 to semiconductor dies 3, 4, an additional bondwire (100) is connected.

Finally, a mold 12 may be integrated in the semiconductor package for protective measures.

Thus, in other words, as depicted in Figures 1a and 1b, a singulated structured glass, either in wafer or panel format, may contain multiple layers of via metallization and top and bottom contact layers. The via metallization extends from the top surface to connect with the bottom lead, creating interconnects for the leadless package.

Positioned within the structured glass package are the top and bottom contact layers (viewed with respect to the glass). Two or more semiconductor dies are attached to the top contact layers and interconnected via the via metallization layers. The glass structure facilitates galvanic inductive isolation through the top and bottom plates on the glass. Subsequently, the device may undergo molding and singulation processes at the panel or wafer level.

The distance between said inductive plate 11 and any of said first and second electrically conductive top plates 7, 8 is preferably in the order of micrometres to tens of micrometres depending on the isolation requirements and the maximum possible height of the package.. This distance can be varied allowing for a range of dimensions of the components of the leadless package (such as the height/thickness of the glass substrate, the height/thickness of the mold compound, the height/thickness of the semiconductor die(s), etc) which can be adjusted but does not reduce performance of the leadless package.

In a preferred embodiment, a distance (h1) is a height of the semiconductor dies 3, 4, a distance (h2) is a height between the bottom and top inductor, a distance (h3) is a height of the said glass substrate 2 and a distance (h4) is a height between the top of the bondwire and topmost edge of the package. The distance (h2) cannot be zero, otherwise the device does not function and is in the order of micrometres to tens of micrometres. The distance (h3) is in the order of hundreds of micrometers, depending on the material used. In an embodiment, if the glass is quartz (silicon dioxide, or SiOz), the thickness (h2) could be in the order of 8 micrometres for a requirement of 4kVrms isolation rating (as it has an electric field strength of around 500 Vrms per micrometre). The combined distance h1+h3+h4 cannot exceed the total package height.

In accordance with another embodiment of the present invention, the inductive plate 11 could also integrate the first and/or second top plates 7, 8 such that the combination of the top and bottom plates form one integrated unit (such as an inductor).

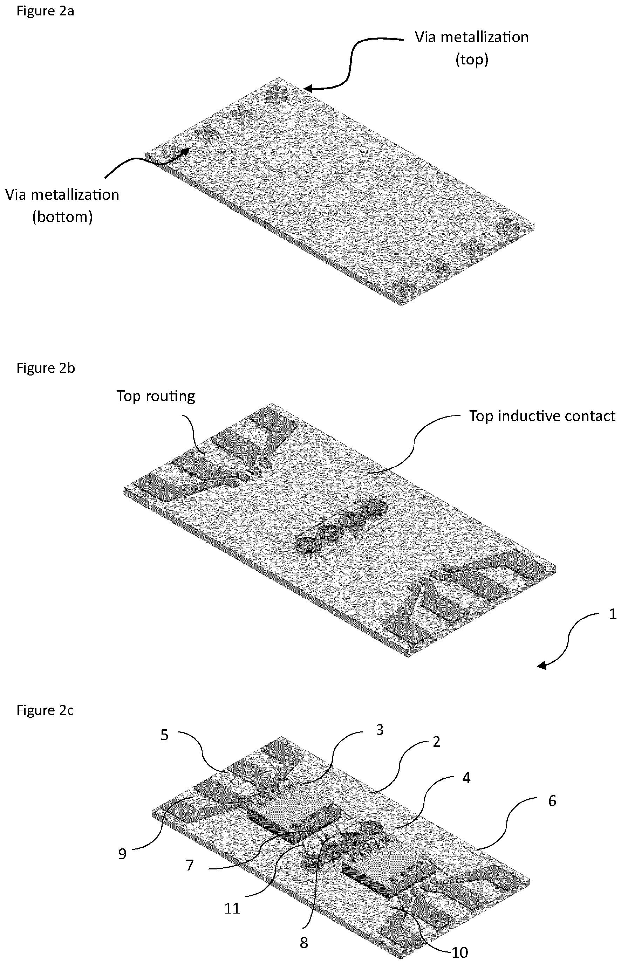

Figs. 2a-2d disclose formation of vias, routing interconnects and inductive contacts in accordance with the present disclosure.

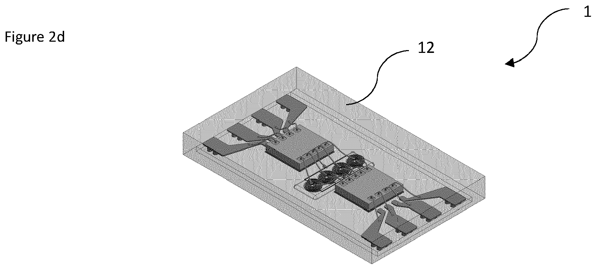

Fig. 2a shows an example of via metallization and the top side of the glass substrate 2 and the bottom side of the glass substrate 2. Fig. 2b shows the interconnect layers, i.e. the routing layers 5, 6, deposited on the top side of the glass substrate 2 for connecting the respective vias to the semiconductor dies 3, 4. Further the top metal plates 11 may be provided for providing one side of the parasitic inductance that is ultimately created. Figure 2c discloses the placement of the semiconductor dies 3, 4 with respect to the routing and inductive contacts. Figure 2d discloses the encapsulation of the package in mold 12 (preferably epoxy).

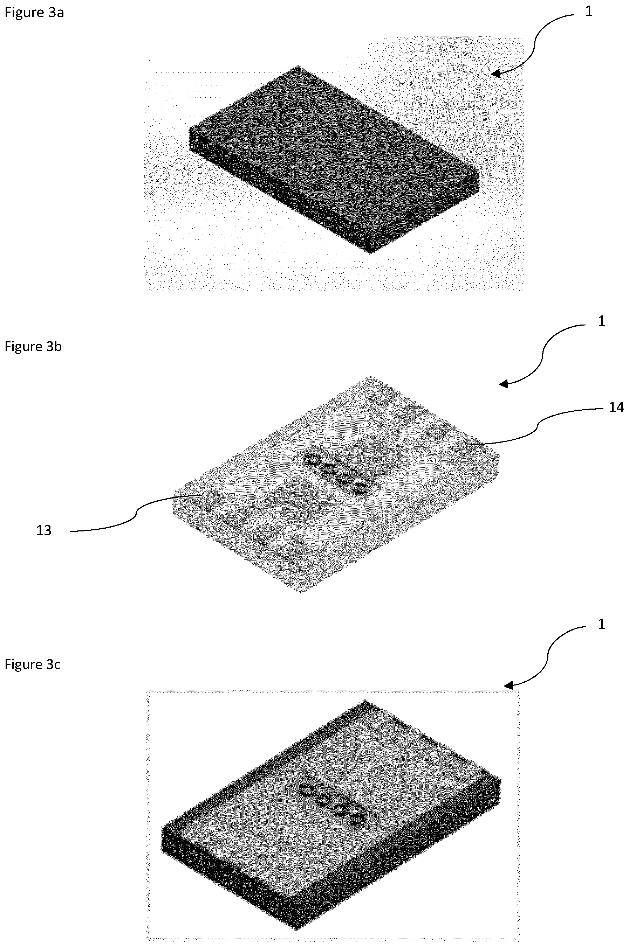

Figs. 3a-3d disclose a semiconductor package assembly in accordance with the present disclosure.

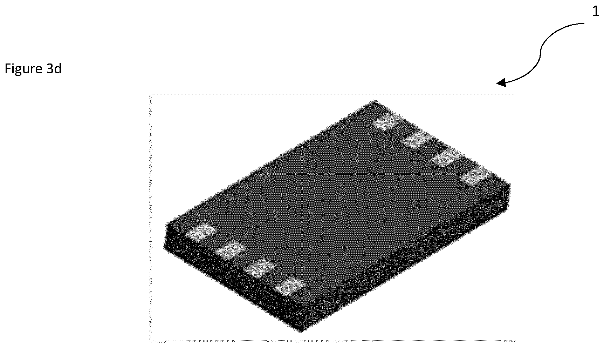

Figure 3a discloses the molding concept, i.e., providing molding 12 to the package 1 as disclosed in Figure 2d. Figure 3b discloses the manufactured leadless package in accordance with the present disclosure. Figure 3c discloses lead plating, wherein additional electrically conductive layers 13, 14, are provided for interconnection purposes. The additional conductive layers 13, 14 may be connected through vias 9, 10 in order to connect to the metal interconnects 5, 6 in the package 1. Finally, Figure 3d discloses the coating of the bottom side of the leadless package.

While Figures 1-4 illustrate a coiled inductor, the invention is not limited thereto.

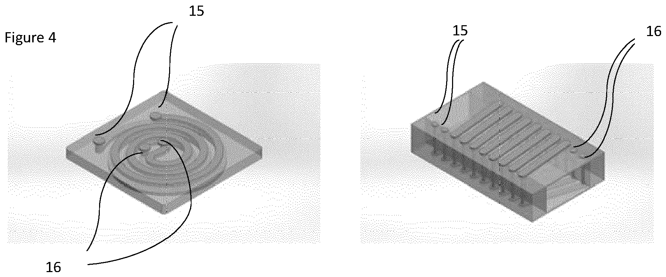

Figure 4 illustrates the shapes of the inductors in the plate 11 according to the present disclosure. On the left figure of Figure 4, two inductors are intertwined and shaped as spiral coils (with the rotation axis of the coils being perpendicular (or normal) to the base of the plate 11 and/or the glass substrate 2. Each coil has a terminal 15, 16 which may be connected to the semiconductor dies 3, 4 via conductive plates 7, 8. The left figure illustrates an embodiment according to the invention where there are two inductor coils intertwined. Such configuration of coils may result in an effective use of the space inside the plate 11. However, these can easily be provided by two separate spiral-shaped inductors for each connection of the semiconductor die(s). The right figure of Figure 4 shows two inductors intertwined and shaped as spiral coils (with the rotation axis of the coils being parallel along the surface to the base of the plate 11 and/or the glass substrate 2. This orientation of the coils may result in being able to increase the number of coils for a given volume of the plate 11.

Other variations to the disclosed embodiments can be understood and effected by those skilled in the art in practicing the claimed invention, from a study of the drawings, the disclosure, and the appended claims. The provided figures and descriptions of the embodiments of the invention are illustrative and explanatory to the heart of the invention and should not be seen as limiting the invention thereto. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A leadless package, comprising:
- a glass substrate;
- first and second electrically conductive interconnect route layers provided on a top side of said glass substrate, wherein the first and second electrically conductive interconnect route layers are isolated from each other;
- first and second electrically conductive top plates provided on said top side of said glass substrate;
- a first semiconductor die having at least two terminals, wherein a first of said two terminals is connected to the first electrically conductive interconnect route layer and a second of said at least two terminals is connected to said first electrically conductive top plate;
- a second semiconductor die having at least two terminals, wherein a first of said two terminals is connected to the second electrically conductive interconnect route layer and a second of said at least two terminals is connected to said second electrically conductive top plate;
- a first via through said glass substrate for enabling an electrical connection from a bottom side of said glass substrate to said first electrically conductive plate;
- a second via through said glass substrate for enabling an electrical connection from said bottom side of said glass substrate to said second electrically conductive plate;
- an inductive plate provided in or at said top side of said glass substrate, wherein said inductive plate is oriented such that an inductive coupling is provided between:
- said first electrically conductive plate and said inductive plate, and
- said second electrically conductive plate and said inductive plate.

2. A leadless package in accordance with claim 1, wherein said inductive plate is electrically floating.

3. A leadless package in accordance with any of the previous claims, wherein said glass substrate is a monolithic glass substrate.

4. A leadless package in accordance with any of the previous claims, wherein any of said terminals of said first and second semiconductor die are connected to said corresponding first or second electrically conductive interconnect route layers or said first or second electrically conductive top plates using an adhesive.

5. A leadless package in accordance with any of the previous claims, wherein any of said terminals of said first and second semiconductor die are connected to said corresponding first or second electrically conductive interconnect route layers or said first or second electrically conductive top plates using solder material.

6. A leadless package in accordance with any of the previous claims, wherein said leadless package further comprises a mold surrounding said first and second semiconductor die.

7. A leadless package in accordance with any of the previous claims, wherein a distance between said inductive plate and any of said first and second electrically conductive top plates is of the order of 8 um for an isolation requirement of 4kVrms.

8. A package in accordance with any of the previous claims, wherein a shape of an inductor of said inductive plate is any of rectangular, square, ellipse, circle, irregular polygons.

9. A package in accordance with any of the previous claims, wherein said first and second semiconductor dies are mounted to said substrate using a flip-chip process.

10. A method of manufacturing a package in accordance with any of the previous claims, wherein said method comprises the steps of:
- providing said glass substrate;
- providing said first and second via through said glass structure;
- depositing said first and second electrically conductive interconnect route layers on said top side of said glass substrate and depositing said first and second electrically conductive top plates on said top side of said glass substrate;
- mounting said first and second semiconductor dies on said substrate, and
- depositing a inductive plate on top of the on the glass substrate between said first and second semiconductor dies.

11. A method in accordance with claim 10, wherein said step of mounting said first and second semiconductor die comprises:
- mounting any of said terminals of said first and second semiconductor die to said corresponding first or second electrically conductive interconnect route layers or said first or second electrically conductive top plates using an adhesive.

12. A method in accordance any of the claims 10 - 11, wherein said step of mounting said first and second semiconductor die comprises:
- mounting any of said terminals of said first and second semiconductor die to said corresponding first or second electrically conductive interconnect route layers or said first or second electrically conductive top plates using solder material.

13. A method in accordance with any of the claims 10 - 12, wherein said method further comprises the step of:
- providing molding to said first and second semiconductor dies such that said package further comprises a mold surrounding said first and second semiconductor die.

14. A method in accordance with any of the claims 10 - 13, wherein a distance between said inductive plate and any of said first and second electrically conductive top plates is of the order of 8 um for an isolation requirement of 4kVrms.

15. A method in accordance with any of the claims 10 - 14, wherein said step of mounting said first and second semiconductor dies on said substrate uses a flip-chip process.
